# FASCICULE DE BREVET EUROPEEN

(11) **EP 0 606 941 B1**
(45) Date de publication et mention de la délivrance du brevet: **15.10.1997**
(21) Numéro de dépôt: 94200027.4
(22) Date de dépôt: 07.01.1994
(51) Int. Cl.: H03L 7/095, H04L 5/06

(54) **Dispositif de synchronisation d'une porteuse locale, pour système "OFDM"**
Einrichtung zur Synchronisierung eines lokalen Trägers, in OFDM-Systemen
Apparatus for the synchronisation of a local carrier in OFDM systems

(30) Priorité: 13.01.1993 FR 9300245
(43) Date de publication de la demande: 20.07.1994
(73) Titulaire: LABORATOIRES D'ELECTRONIQUE PHILIPS S.A.S., 94450 Limeil-Brévannes (FR); Philips Electronics N.V., 5621 BA Eindhoven (NL)
(72) Inventeur: Daffara, Flavio, Société Civile S.P.I.D., F-75008 Paris (FR)
(74) Mandataire: Landousy, Christian

(56) Documents cités:
- WO-A-92/10043
- US-A- 4 473 805
- US-A- 4 724 401
- US-A- 5 065 107
- IEEE TRANSACTIONS ON MICROWAVE THEORY AND TECHNIQUES, vol.36, no.9, Septembre 1988, New York, US, pp 1362-1366; BERENGUER I SAU: 'A new lock indicator circuit for microwave and millimeter-wave phase locked loops'

## Description

L'invention concerne un dispositif de synchronisation de porteuse pour estimer et compenser des écarts de synchronisation entre une porteuse locale et un signal modulé reçu à démoduler par la porteuse locale générée par ledit dispositif, celui-ci comprenant :
- des moyens pour déterminer un signal d'erreur ε(t) caractérisant une désynchronisation entre le signal modulé reçu et la porteuse locale,
- un oscillateur local, commandé par un signal de commande u(t), qui génère la porteuse locale,
- au moins deux filtres passe-bas, connectés en parallèle entre lesdits moyens et l'oscillateur local, les deux filtres filtrant le signal d'erreur et donnant des bandes de boucle différentes,
- un détecteur de mode d'asservissement qui fournit un signal de sélection pour sélectionner un des filtres, la sortie du filtre sélectionné fournissant ledit signal de commande u(t).

Elle concerne également une application de ce dispositif à la synchronisation de signaux émis selon une norme OFDM (Orthogonal Frequency Time Multiplexing).

Un tel dispositif de synchronisation est par exemple décrit dans le document JP. KOKAI - 60 16731. Il décrit un circuit formé d'une boucle à asservissement de phase qui détermine un signal d'erreur caractérisant une désynchronisation, le signal d'erreur pouvant être filtré soit par un premier filtre soit par un second filtre ayant des bandes passantes différentes de sorte que le signal d'erreur ainsi filtré donne naissance à un signal de commande qui agit sur un oscillateur local. Le signal généré par cet oscillateur local est combiné avec le signal reçu pour générer le signal d'erreur. La mise en action de l'un ou de l'autre filtre, selon que le dispositif est en mode d'accrochage ou en mode d'acquisition, dépend d'un circuit discriminateur qui détecte le mode de fonctionnement et sélectionne le filtre le mieux approprié afin de réduire le bruit FM et d'améliorer les performances du dispositif.

Rien n'est révélé quant à la façon selon laquelle opère le circuit discriminateur. On peut seulement inférer que le dispositif opère une détection de phase et que le circuit discriminateur sélectionne le mode de fonctionnement par une mesure liée à la phase.

Or, il existe des situations où il faut tenir également compte des écarts de fréquences. D'autre part, le circuit discriminateur est fixe et n'est pas auto-adaptable aux modes de fonctionnement acquisition/accrochage.

Une application particulière du dispositif se situe dans la réception de signaux émis selon une répartition multiplexée de fréquences orthogonales (OFDM), transmis notamment par voie hertzienne, par câble, par satellite, par exemple pour des applications en télévision numérique. Pour des applications telles que la transmission d'images de télévision par modulation OFDM, une détection de phase est inopérante. Par ailleurs, pour des applications destinées à une large diffusion, il est souhaitable que les dispositifs soient non seulement robustes et précis mais également qu'ils aient un coût faible.

La technique d'émission de signaux selon une répartition multiplexée de N fréquences orthogonales consiste à fractionner une information à transmettre en la répartissant sur un grand nombre de canaux élémentaires à bas débit 1/T, T étant la durée symbole. On transforme ainsi un canal à large bande fortement sélectif en un grand nombre de canaux élémentaires non sélectifs. Comme l'ensemble constitue un canal à large bande, il est peu probable que des évanouissements en cours de transmission affectent simultanément la totalité du canal. Cette technique permet également de réduire les brouillages intersymboles.

A chaque canal élémentaire correspond alors une fréquence, l'ensemble des fréquences étant symétriquement réparti autour d'une fréquence porteuse. Comme à la réception il est difficilement acceptable d'utiliser des filtres sélectifs, on préfère tolérer un recouvrement des spectres mais en imposant des conditions d'orthogonalité entre les fréquences pour éliminer l'interférence intersymbole aux instants d'échantillonnage. L'ensemble du spectre d'un signal OFDM tend ainsi vers un spectre rectangulaire.

A la réception, les signaux reçus doivent être démodulés puis décodés pour restituer les informations d'origine. Cette démodulation met en oeuvre un oscillateur local dont la fréquence doit être asservie à la fréquence porteuse du signal reçu.

Un but de l'invention est ainsi de permettre au dispositif de synchronisation de porteuse de synchroniser une porteuse générée localement avec un signal modulé reçu, la synchronisation s'opérant avec des constantes de temps de boucle adaptées, de manière autoprogrammable, aux modes de fonctionnement.

Ce but est atteint avec un dispositif de synchronisation dans lequel, pour délivrer le signal de sélection, le détecteur de mode d'asservissement calcule des écarts entre le signal de commande et au moins une réplique dudit signal de commande retardé par des moyens de retard programmables qui appliquent des retards dédiés à chaque filtre, des moyens de comparaison comparant les écarts à au moins un seuil prédéterminé pour délivrer le signal de sélection qui détermine le filtre à sélectionner.

Ainsi avantageusement ledit dispositif réduit les écarts de fréquence entre le signal modulé reçu et la porteuse locale grâce à l'utilisation d'un signal de commande u(t) (signal d'erreur filtré) qui est proportionnel à la fréquence. Le basculement d'un filtre à l'autre est effectué de manière autoprogrammable par le dispositif.

Préférentiellement, les moyens qui déterminent le signal de désynchronisation comprennent soit un détecteur de fréquence soit un détecteur de phase qui mesure la désynchronisation en calculant la différence respectivement de fréquence ou de phase entre le signal reçu et la porteuse locale.

Ce dispositif est particulièrement intéressant pour assurer l'asservissement de la fréquence de réception d'un récepteur sur la fréquence d'émission. Pour cela, il faut basculer d'un mode d'acquisition vers un mode d'accrochage et réciproquement selon les conditions de transmission opérées par le canal de transmission. Le dispositif de synchronisation de porteuse doit passer d'un mode à l'autre. Dans ce but, pour faire opérer ledit dispositif en mode d'acquisition, ou pour faire opérer ledit dispositif en mode d'accrochage, les moyens de retard respectivement soit mettent en oeuvre un premier retard et sélectionnent un premier filtre donnant une bande de boucle large, soit mettent en oeuvre un second retard plus petit que le premier retard et sélectionnent un second filtre donnant une bande de boucle étroite.

Le dispositif peut être utilisé pour la synchronisation de signaux OFDM qui sont formatés par blocs dont un bloc au moins est un bloc répétitif de synchronisation. Selon un mode particulier de réalisation de l'invention, le détecteur de fréquence détermine le signal d'erreur à partir de ce(ces) bloc(s) répétitif(s) de synchronisation. Le premier et le second retard peuvent alors valoir un nombre entier de fois la cadence d'émission des blocs de synchronisation.

Avantageusement ceci permet d'améliorer le comportement du dispositif au cours de la phase d'acquisition.

Ces différents aspects de l'invention et d'autres encore seront apparents et élucidés à partir des modes de réalisation décrits ci-après.

L'invention sera mieux comprise à l'aide des figures suivantes données à titre d'exemples non limitatifs qui représentent :

Figure 1 : une représentation schématique d'un récepteur muni d'un dispositif de synchronisation de porteuse selon l'invention.

Figure 2 : un schéma d'un détecteur de mode d'asservissement acquisition / accrochage.

Figure 3 : un schéma d'un exemple de réalisation des moyens de retard programmables.

Figures 4 et 5 : des schémas de filtres passe-bas pour des réalisations analogiques et numériques.

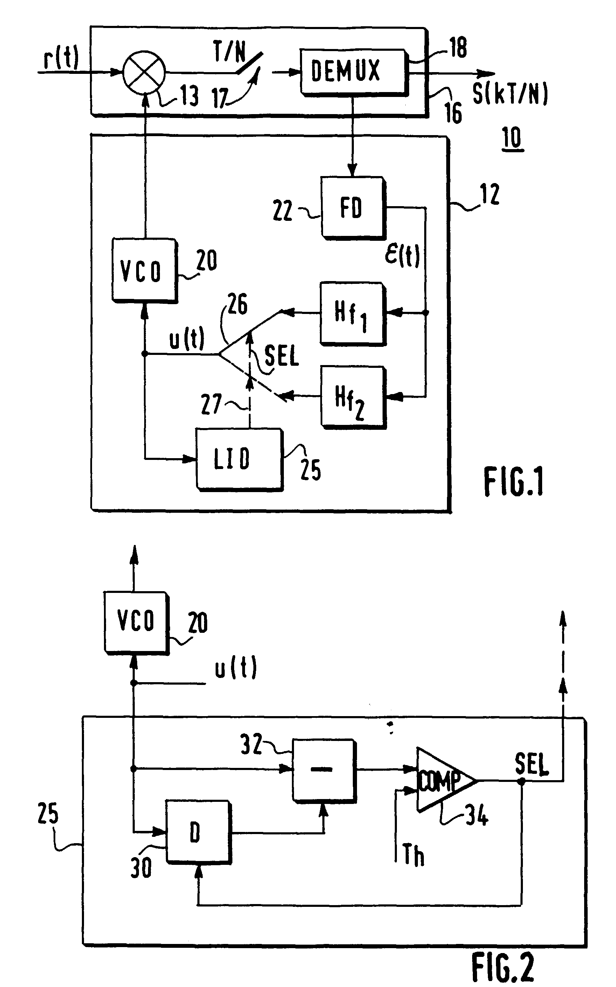

La figure 1 représente schématiquement un récepteur 10 comprenant un démodulateur 16 et d'un dispositif 12 de synchronisation de fréquence de porteuse. Le signal modulé r(t) reçu par le démodulateur 16 est combiné dans un mélangeur 13 avec une porteuse générée localement par un oscillateur local par exemple un oscillateur 20 contrôlé en tension VCO. La sortie du mélangeur 13 fournit un signal en bande de base qui entre dans un échantillonneur 17 (cadence T/N) et un démultiplexeur 18 qui délivre un signal démodulé échantillonné s(kT/N). Pour asservir la fréquence de l'oscillateur à la fréquence du signal modulé reçu, on utilise le dispositif de synchronisation 12 qui fonctionne en boucle. Pour cela, il reçoit du démultiplexeur 18 des données desquelles sont extraites des informations de désynchronisation qui servent à asservir la fréquence de la porteuse générée par l'oscillateur local 20.

La désynchronisation est estimée, par exemple, à l'aide d'un détecteur de fréquence FD 22 qui détermine l'écart de fréquence entre r(t) et la fréquence de l'oscillateur local et qui génère un signal d'erreur ε(t). Un détecteur de fréquence 22 pour signaux OFDM peut être, par exemple, celui décrit dans la demande WO 92/16063. Le signal d'erreur entre, en parallèle, dans deux filtres passe-bas Hf₁ et Hf₂ dont les sorties peuvent être sélectionnées pour délivrer un signal de commande u(t). Pour déterminer l'instant où il faut commuter du filtre Hf₁ (mode d'acquisition) au filtre Hf₂ (mode d'accrochage) et inversement, on utilise un détecteur LID 25 de mode d'asservissement. Le détecteur LID 25 de mode d'asservissement opère cette sélection en agissant sur un sélecteur 26. Le détecteur 25 exploite le signal de commande u(t) pour délivrer un signal de sélection SEL 27 qui sélectionne l'un ou l'autre filtre.

La figure 2 représente un schéma du détecteur 25. Il comprend des moyens 30 de retard programmable, qui appliquent un retard D, et un soustracteur 32 qui reçoivent tous les deux le signal de commande u(t). Le soustracteur calcule des écarts entre le signal de commande u(t) et une réplique du même signal retardé par les moyens 30. Les écarts sont comparés à un seuil Th dans un comparateur 34. Celui-ci délivre un signal de sélection SEL qui agit sur le sélecteur 26 placé en sortie des filtres. Le sélecteur 26 peut être placé avant les filtres. Le signal de sélection SEL agit également sur les moyens de retard 30 pour sélectionner chaque retard dédié à chaque filtre et rendre le dispositif autoprogrammable.

Le retard D est mis à une valeur faible durant le mode d'accrochage pour que le dispositif de synchronisation réponde rapidement aux changements de fréquence. De même, le retard D est augmenté au début de la période d'acquisition afin de réduire le problème de faux accrochage.

Les caractéristiques des filtres doivent être choisies afin de fournir une durée d'acquisition acceptable ainsi qu'une variance d'erreur σ² aussi faible que possible et une erreur moyenne nulle dans des conditions de fréquence stable. Une durée d'acquisition acceptable est le résultat d'un compromis entre une durée d'acquisition la plus courte possible et une gigue faible.

On peut définir la durée d'acquisition Tacq comme étant la durée nécessaire à réduire l'erreur normalisée de fréquence à une valeur moyenne inférieure à 0,02. En prenant exemple sur un signal OFDM, on peut choisir un filtre Hf₁ qui donne une boucle du second ordre ayant une bande passante normalisée B₁.T_{f} = 2 (T_{f} étant la durée entre deux blocs de synchronisation) et un facteur d'amortissement de 20. Dans ce cas, en présence d'un bruit additif gaussien, on obtient une durée d'acquisition qui est de l'ordre de 15 blocs de synchronisation pour un écart initial de fréquence de Δf.T_{S} = 5 (avec Δf = 31,25 kHz et une durée symbole T_{S} = 160 microsecondes). En fin d'accrochage, la stabilisation en fréquence est estimée par la variance de Δf.T_{S}. Avec un rapport S/N = 30 dB, on a σ² = 9.10⁻⁵ et avec S/N = 13 dB on a σ² = 1,5.10⁻⁴. Mais au cours de la phase d'accrochage, le filtre Hf₁ seul ne peut pas traiter correctement les problèmes à cause de la gigue et de la présence d'un écart de fréquence résiduelle qui dure pendant une longue période. Aussi, pour réduire la gigue durant la phase d'accrochage, on lui substitue un second filtre Hf₂ donnant une boucle ayant une bande passante plus étroite que celle donnée par le filtre Hf₁. Par exemple, le filtre Hf₂ peut donner une boucle du premier ordre telle que la largeur de bande normalisée est B₁.T_{f} = 0,25. Avec le filtre Hf₂, on obtient en fin d'accrochage une stabilisation en fréquence ayant une variance σ² = 2.10⁻⁸ pour S/N = 30 dB et une variance σ² = 3.10⁻⁶ pour S/N = 13 dB.

On observe ainsi que la stabilisation en fréquence est améliorée en phase d'accrochage lorsque le filtre Hf₂ est utilisé.

Les filtres Hf₁ et Hf₂ peuvent être réalisés en analogique ou en numérique. Il est possible de mettre plus de deux filtres.

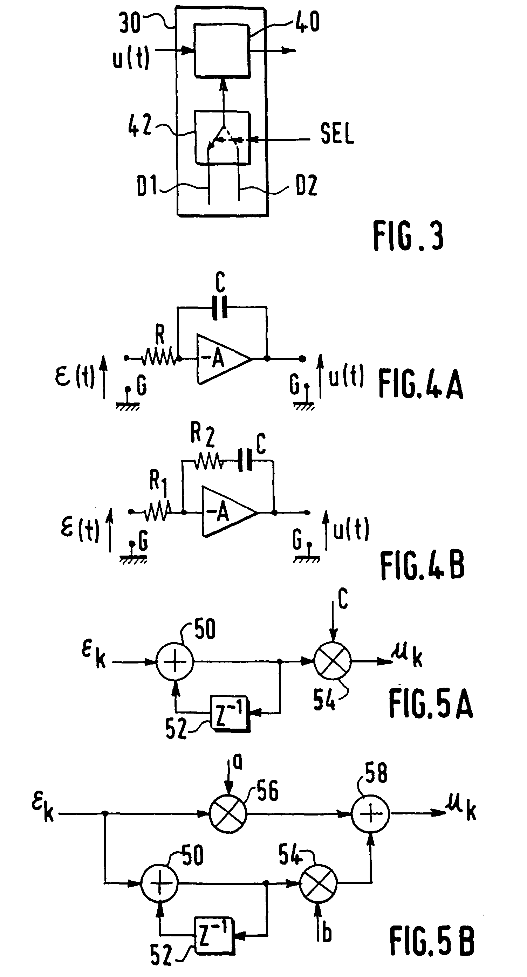

La figure 3 représente un schéma d'un exemple de réalisation des moyens de retard 30. Ils comprennent un organe de retard 40 tel qu'un registre à décalage (dans une réalisation en numérique) ou une ligne à retard (dans une réalisation en analogique). Ces moyens de retard 30 sont programmés pour appliquer une valeur de retard à l'aide d'un sélecteur 42 qui sélectionne soit un retard D1 soit un retard D2. Le sélecteur est commandé par le signal de sélection SEL.

Les valeurs D1 et D2 des retards dépendent de l'application dans laquelle opère le dispositif de synchronisation. Toujours dans le cadre de l'exemple OFDM, avec les paramètres des filtres Hf₁ et Hf₂ donnés précédemment, le retard D a par exemple été programmé pour passer de 3 Tf à Tf correspondant respectivement au mode d'acquisition et au mode d'accrochage (Tf = durée d'une trame OFDM). La valeur du seuil Th a été fixée à 0,8.

La figure 4 représente un exemple de réalisation de filtres analogiques. Sur la figure 4-A, un amplificateur de gain -A reçoit le signal d'entrée ε(t) à travers une résistance R. L'entrée de l'amplificateur est réunie à sa sortie par une capacité C de contre-réaction. Le signal filtré u(t) apparaît, par rapport à une masse G, en sortie de l'amplificateur. Lorsque le dispositif de synchronisation 12 (figure 1) opère avec le filtre de la figure 4-A, la boucle est de premier ordre. Elle devient du second ordre avec un filtre représenté par la figure 4-B. La différence avec la figure 4-A consiste à placer une résistance R2 en série avec la capacité C et à ajuster les valeurs des éléments R1 et C.

Il est possible de réaliser les filtres Hf₁, Hf₂ en numérique. Les figures 5-A, 5-B sont, en numérique, des filtres équivalents à ceux respectivement des figures 4-A et 4-B. Dans ce cas, les signaux sont des signaux numérisés εₖ et uₖ. Le signal εₖ est additionné, dans un sommateur 50, à un signal formé par une réplique retardée par le retardateur 52 du signal de sortie du sommateur 50. La sortie du sommateur est également réunie à l'entrée d'un multiplieur 54 qui multiplie le signal de sortie du sommateur par un coefficient de pondération c pour délivrer le signal filtré uₖ. Le filtre 5-A sert à construire une boucle du premier ordre.

La figure 5-B représente un filtre permettant de construire une boucle du second ordre. Il comprend également un sommateur 50, un retardateur 52 et un multiplieur 54 connectés de la même manière que sur la figure 5-A. Le multiplieur 54 reçoit un coefficient b. L'entrée du sommateur reçoit le signal εₖ qui entre également dans un multiplieur 56 (coefficient de pondération a) dont la sortie est connectée à un sommateur 58 qui reçoit aussi la sortie du multiplieur 54. La sortie du sommateur 58 délivre le signal filtré uₖ.

En mode d'acquisition, on utilise un filtre Hf₁ donnant une boucle du second ordre et en mode d'accrochage, on utilise un filtre Hf₂ donnant une boucle du premier ordre.

## Revendications

1. Dispositif (12) de synchronisation de porteuse pour estimer et compenser des écarts de synchronisation entre une porteuse locale et un signal modulé reçu à démoduler par la porteuse locale générée par ledit dispositif, celui-ci comprenant :
- des moyens (22) pour déterminer un signal d'erreur ε(t) caractérisant une désynchronisation entre le signal modulé reçu et la porteuse locale,
- un oscillateur local (20), commandé par un signal de commande (u(t)), qui génère la porteuse locale,
- au moins deux filtres passe-bas (Hf₁, Hf₂), connectés en parallèle entre lesdits moyens (22) et l'oscillateur local, les deux filtres filtrant le signal d'erreur et donnant des bandes de boucle différentes,
- un détecteur (25) de mode d'asservissement qui fournit un signal de sélection (SEL) pour sélectionner un des filtres, la sortie du filtre sélectionné fournissant ledit signal de commande (u(t)),
caractérisé en ce que le détecteur (25) de mode d'asservissement calcule des écarts entre le signal de commande (u(t)) et au moins une réplique dudit signal de commande retardé par des moyens (30) de retard programmables qui appliquent des retards dédiés à chaque filtre, des moyens de comparaison (34) comparant les écarts à au moins un seuil prédéterminé (Th) pour délivrer le signal de sélection qui détermine le filtre à sélectionner.

2. Dispositif selon la revendication 1 caractérisé en ce que lesdits moyens (22) comprennent soit un détecteur de fréquence soit un détecteur de phase qui mesure la désynchronisation en calculant la différence respectivement de fréquence ou de phase entre le signal reçu et la porteuse locale.

3. Dispositif selon les revendications 1 ou 2 caractérisé en ce que pour faire opérer ledit dispositif en mode d'acquisition, ou pour faire opérer ledit dispositif en mode d'accrochage, les moyens (30) de retard respectivement soit mettent en oeuvre un premier retard et sélectionnent un premier filtre donnant une bande de boucle large, soit mettent en oeuvre un second retard plus petit que le premier retard et sélectionnent un second filtre donnant une bande de boucle étroite.

4. Application d'un dispositif selon une des revendications 1 à 3, à la synchronisation de signaux OFDM formatés par blocs dont un bloc au moins est un bloc répétitif de synchronisation, caractérisé en ce que le détecteur de fréquence détermine le signal d'erreur en estimant une désynchronisation des blocs de synchronisation reçus.

5. Application selon la revendication 4 caractérisé en ce que le premier retard et le second retard valent un nombre entier de fois la cadence d'émission des blocs de synchronisation.

## Patentansprüche

1. Eine Einrichtung (12) zur Synchronisierung eines Trägers für die Bewertung und den Ausgleich der Synchronisationsabweichungen zwischen einem lokalen Träger und einem für die Demodulation vom lokalen Träger erhaltenen modulierten Signal, das von der besagten Einrichtung erzeugt wurde und folgendes beinhaltet :
- Mittel (22) zur Bestimmung eines Signalsfehlers ε(t) mit dem Merkmal einer Desynchronisation zwischen dem empfangenen Modulationssignal und dem lokalen Träger,
- einen von einem Steuersignal [u(t)] gesteuerten lokalen Oszillator (20), der den lokalen Träger erzeugt,
- mindestens zwei parallel zwischen die besagten Mittel (22) und den lokalen Oszillator angeschlossene Tiefpaßfilter (Hf₁, Hf₂), wobei diese beiden Filter das Fehlersignal filtern und unterschiedliche Schleifenfrequenzen liefern,
- ein Regelmodusdetektor (25), der für die Auswahl einer der Filter ein Auswahlsignal (SEL) abgibt, wobei der Ausgang des ausgewählten Filters das besagte Steuersignal [u(t)] liefert,
mit dem Merkmal, daß der Regelmodusdetektor (25) die Abweichungen zwischen dem Steuersignal [u(t)] und mindestens einem Duplikat des besagten Steuersignals berechnet, verzögert über programmierbare Verzögerungsmittel (30), die jedem Filter geeignete Verzögerungen zuweisen, während die Vergleichsmittel (34) die Abweichungen mit mindestens einer vorbestimmten Schwelle (Th) vergleichen, um das Auswahlsignal abzugeben, das den zu wählenden Filter bestimmt.

2. Eine Einrichtung laut Anspruch 1, mit dem Merkmal, daß die besagten Mittel (22) entweder einen Frequenzdetektor oder einen Phasendetektor enthalten, der die Desynchronisation mißt, indem er den jeweiligen Frequenz- oder Phasenunterschied zwischen dem empfangenen Signal und dem lokalen Träger berechnet.

3. Eine Einrichtung laut den Ansprüchen 1 oder 2, mit dem Merkmal, daß die Verzögerungsmittel (30), um die besagte Einrichtung entweder in Erfassungsmodus oder in Einschwingungsmodus arbeiten zu lassen, entweder eine erste Verzögerung bewirken und einen ersten Filter für den Erhalt einer breiten Schleife wählen, oder eine unter der ersten Verzögerung liegende zweite Verzögerung bewirken und einen zweiten Filter für den Erhalt einer engen Schleifenfrequenz wählen.

4. Die Verwendung einer Einrichtung laut einem der Ansprüche 1 bis 3 zur Synchronisierung von OFDM-Signalen, in Blöcken formatiert, von denen mindestens ein Block ein Synchronisierungswiederholungsblock ist,
mit dem Merkmal, daß der Frequenzdetektor das Fehlersignal durch die Bewertung der Desynchronisation der empfangenen Synchronisationsblöcke bestimmt.

5. Die Verwendung laut Anspruch 4, mit dem Merkmal, daß die erste Verzögerung und die zweite Verzögerung den Wert einer Ganzzahl mal dem Übertragungstakt der Synchronisierungsblöcke aufweisen.

## Claims

1. A carrier synchronization device (12) for determining and compensating for differences in synchronization between a local carrier and a received modulated signal to be demodulated by the local carrier generated by said device, the device comprising:
- means (22) for determining an error signal ε(t) representative of a synchronization error between the received modulated signal and the local carrier,
- a local oscillator (20) which generates the local carrier under control of a control signal (u(t)),
- at least two low-pass filters (Hf₁, Hf₂) connected in parallel between said means (22) and the local oscillator, the two filters filtering the error signal and providing different loop bandwidths,
- a lock mode detector (25), which supplies a selection signal (SEL) for selecting one of the filters, the output of the selected filter supplying said control signal (u(t)),
characterized in that said lock mode detector (25) calculates differences between the control signal (u(t)) and at least one replica of said control signal delayed by programmable delay means (30), which delay means produce specific delays for each filter, the differences being compared with at least one predetermined threshold (Th) by comparison means (34) in order to supply the selection signal which determines the filter to be selected.

2. A device as claimed in Claim 1, characterized in that said means (22) comprise either a frequency detector or a phase detector, which measures the synchronization error by, respectively, calculating the frequency difference or the phase difference between the received signal and the local carrier.

3. A device as claimed in Claim 1 or 2, characterized in that the delay means (30) apply a first delay and select a first filter providing a large loop bandwidth, in order to cause said device to operate in the capturing mode, and the delay means apply a second delay smaller than the first delay and select a second filter providing a narrow loop bandwidth, in order to cause said device to operate in the lock-in mode.

4. A use of a device as claimed in any one of the Claims 1 to 3, for the synchronization of block-format OFDM signals of which at least one block is a repetitive synchronization block, characterized in that the frequency detector determines the error signal by determining a synchronization error of the received synchronization blocks.

5. A use as claimed in Claim 4, characterized in that the first delay and the second delay are equal to an integral multiple of the transmission rate of the synchronization blocks.
